# EUROPEAN PATENT APPLICATION

(11) **EP 4 626 213 A1**
(43) Date of publication of application: **01.10.2025**
(21) Application number: 22966471.9
(22) Date of filing: 22.11.2022
(51) Int. Cl.: H10N 60/12, G06N 10/40, H10N 60/01

(54) **DEVICE AND MANUFACTURING METHOD FOR DEVICE**

(71) Applicant: FUJITSU LIMITED, Kawasaki-shi, Kanagawa 211-8588 (JP)
(72) Inventor: SHIMANOUCHI, Takeaki, Kawasaki-shi, Kanagawa 211-8588 (JP)
(74) Representative: Hoffmann Eitle
(86) International application number: PCT/JP2022/043203
(87) International publication number: WO 2024/111061

(57) **Abstract**

[Problem]

In order to perform a multi-qubit gate computation in a quantum computer, it is necessary to capacitively couple a plurality of qubits, but the number of qubits that can be capacitively coupled in an actual device is limited.

[Means of Solution]

The number of qubits that can be capacitively coupled can be increased by not only capacitively coupling a plurality of qubits formed on the same substrate, but also capacitively coupling the qubits of the substrate to qubits formed in another substrate that is bonded to the substrate.

## Description

### TECHNICAL FIELD

The present disclosure relates to devices, and manufacturing methods for the devices.

### BACKGROUND ART

In recent years, research and development of quantum computers utilizing quantum phenomena have advanced. As qubits constituting a quantum computer, devices utilizing transmons are attracting attention. A transmon is a type of quantum bit device that includes a capacitor and a Josephson device formed using a superconducting material. The quantum computer has a plurality of quantum bit devices, and can perform high-speed computations by controlling the plurality of qubits.

### PRIOR ART DOCUMENTS

### PATENT DOCUMENTS

Patent Document 1: Japanese Laid-Open Patent Publication No. 2020-61447
Patent Document 2: Japanese National Publication of International Patent Application No. 2021-504956

### DISCLOSURE OF THE INVENTION

### PROBLEM TO BE SOLVED BY THE INVENTION

The quantum computer is a computer utilizing phenomena, such as quantum superposition and quantum entanglement. In order to perform a multi-qubit gate computation in the quantum computer, it is necessary to capacitively couple the plurality of qubits to one another, however, in an actual device, there are layout limitations, thereby limiting a number of qubits that can be capacitively coupled. For this reason, a technique for increasing the number of qubits that can be capacitively coupled is desired.

### MEANS OF SOLVING THE PROBLEM

A device that is provided is characterized in that there are provided a first qubit substrate; a second qubit substrate; a coupling capacitor substrate; a first bump; and a second bump mutually connecting the first qubit substrate and the coupling capacitor substrate, wherein the first qubit substrate includes a first qubit formed on a first surface of the first qubit substrate, the second qubit substrate includes a second qubit formed on a first surface of the second qubit substrate, the coupling capacitor substrate includes a first capacitor electrode, and a second capacitor electrode capacitively coupled to the first capacitor electrode, the first qubit substrate and the coupling capacitor substrate are connected via the first bump so that the first surface of the first qubit opposes the coupling capacitor substrate, the second qubit substrate and the coupling capacitor substrate are connected via the second bump so that the first surface of the second qubit substrate opposes the coupling capacitor substrate, the first qubit and the first bump are electrically connected, the second qubit and the second bump are electrically connected, the first capacitor electrode and the first bump are electrically connected, and the second capacitor electrode and the second bump are electrically connected.

### EFFECTS OF THE INVENTION

By the means described above, the qubits can be capacitively coupled not only to qubits formed on the same qubit substrate, but also to qubits of other qubit substrates.

### BRIEF DESCRIPTION OF THE DRAWINGS

[FIG. 1] FIG. 1 is a diagram illustrating an overall configuration of a quantum computer.
[FIG. 2] FIG. 2 is a plan view of a qubit substrate on which quantum bit devices are formed.
[FIG. 3] FIG. 3 is a diagram illustrating a quantum bit device including a Josephson junction.
[FIG. 4] FIG. 4 is a diagram illustrating a port connectivity between a readout port and a control port with respect to a quantum bit device.
[FIG. 5] FIG. 5 is a conceptual diagram illustrating a state where quantum bit devices are capacitively coupled.
[FIG. 6] FIG. 6 is a diagram (part 1) illustrating a manufacturing process of the qubit substrate according to a first embodiment.
[FIG. 7] FIG. 7 is a diagram (part 2) illustrating a manufacturing process of the qubit substrate according to the first embodiment.
[FIG. 8] FIG. 8 is a diagram (part 3) illustrating a manufacturing process of the qubit substrate according to the first embodiment.
[FIG. 9] FIG. 9 is a diagram (part 4) illustrating a manufacturing process of the qubit substrate according to the first embodiment.
[FIG. 10] FIG. 10 is a diagram illustrating a manufacturing process of a Josephson device according to the first embodiment.
[FIG. 11] FIG. 11 is a diagram (part 1) illustrating a manufacturing process of a coupling capacitor substrate according to the first embodiment.
[FIG. 12] FIG. 12 is a diagram (part 2) illustrating a manufacturing process of the coupling capacitor substrate according to the first embodiment.
[FIG. 13] FIG. 13 is a cross sectional view of a quantum device according to the first embodiment.
[FIG. 14] FIG. 14 is a diagram for explaining a method of controlling the quantum device according to the first embodiment.
[FIG. 15] FIG. 15 is a cross sectional view of the quantum device according to a second embodiment.
[FIG. 16] FIG. 16 is a diagram illustrating a structure of the coupling capacitor substrate according to a third embodiment.

### MODE OF CARRYING OUT THE INVENTION

### <First Embodiment>

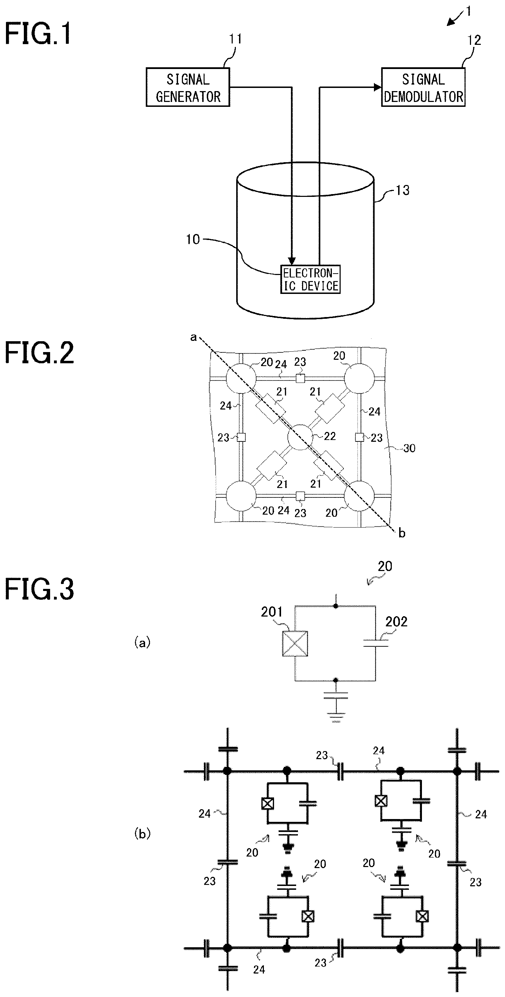

FIG. 1 is a diagram illustrating an overall configuration of a quantum computer. A quantum computer 1 includes a quantum device 10, a signal generator 11, a signal demodulator 12, and a refrigerator 13. The quantum device 10 is accommodated within the refrigerator 13 and is cooled. The signal generator 11 generates a microwave pulse signal, and the microwave pulse signal is input to the quantum device 10. The quantum device 10 outputs a signal according to the microwave pulse signal, and the signal demodulator 12 demodulates the signal output from the quantum device 10. The signal generator 11 and the signal demodulator 12 are used at room temperature, for example.

FIG. 2 is a plan view of a qubit substrate on which quantum bit devices are formed. The quantum device 10 includes quantum bit (qubit) devices 20 provided on a qubit substrate 30, resonators 21, a readout port 22, capacitors 23, and inter-qubit interconnects 24. The resonator 21 is connected to the qubit device 20. Although not illustrated, a filter may be provided between the resonator 21 and the readout port 22. The resonator 21 generates a bit signal indicating a state of the qubit device 20 by interacting with the qubit device 20. The readout port 22 is an electrode connected to the resonator 21 for extracting the bit signal generated by the resonator 21 to the outside. A plurality of qubit devices 20 are connected to other adjacent qubit devices 20 via the inter-qubit interconnects 24. The capacitor 23 is provided on a path of the inter-qubit interconnect 24. In other words, the plurality of qubit devices 20 are capacitively coupled to one another via the capacitors 23.

FIG. 3 is a diagram illustrating a qubit device including a Josephson junction. In FIG. 3 (a), the qubit device 20 performs a quantum computation using nonlinear energy, and includes a transmon qubit circuit in which a Josephson device 201 and a capacitor 202 are connected in parallel. The Josephson device 201 includes a pair of superconductors that exhibit superconductivity at a temperature lower than or equal to a predetermined critical temperature, and an insulator sandwiched between the pair of superconductors. The superconductor is aluminum, for example, and the insulator is aluminum oxide, for example.

FIG. 3 (b) illustrates a state where the qubit devices illustrated in FIG. 3 (a) are capacitively coupled to one another. By capacitively coupling the qubit devices to one another, each qubit device 20 produces a quantum entanglement state with another adjacent qubit device 20 to perform a quantum computation.

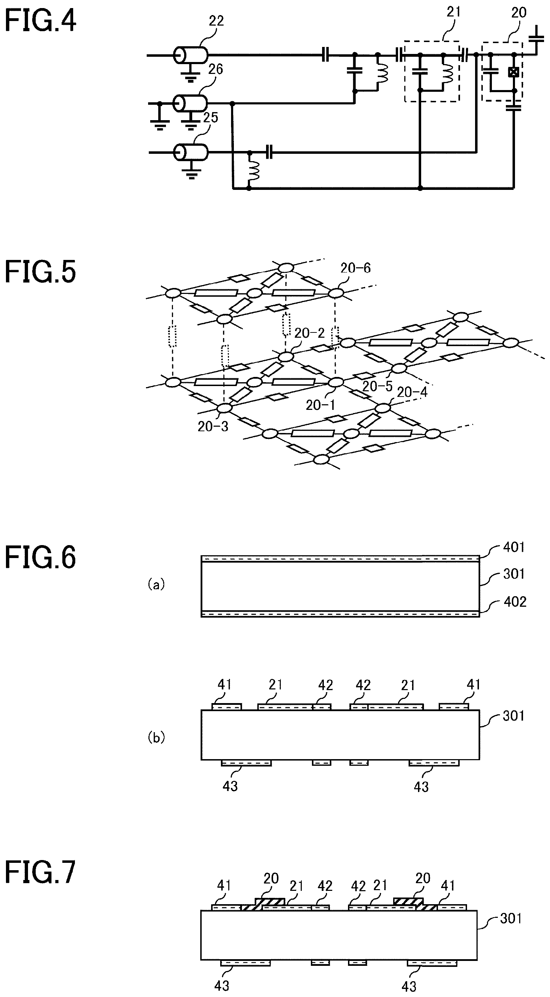

FIG. 4 is a diagram illustrating a port connectivity between the readout port and a control port with respect to the qubit device. A control port 25 is connected to the qubit device 20 via a coupling capacitor. In a case where a readout processing is performed with respect to the qubit device 20, a control signal having a predetermined frequency is input to the control port 25. The readout port 22 is connected to the qubit device 20 via the resonator 21 and a filter. In a case where the control signal is input to the control port 25, a bit signal according to the state of the qubit device 20 is generated by the resonator 21, and the bit signal generated by the resonator 21 is read out from the readout port 22. The filter removes noise from the bit signal. A ground port 26 is connected to the filter, the resonator 21, and the qubit device 20, to apply a ground potential to these devices.

FIG. 5 is a conceptual diagram illustrating a state where qubit devices are capacitively coupled. Qubit devices 20-1 through 20-5 are qubit devices located on the same plane. The qubit device 20-1 and the qubit device 20-2, the qubit device 20-1 and the qubit device 20-3, the qubit device 20-1 and the qubit device 20-4, and the qubit device 20-1 and the qubit device 20-5 are capacitively coupled, respectively. Further, the qubit device 20-1 is also capacitively coupled to a qubit device 20-6 located on a plane different from the plane on which the qubit devices 20-1 through 20-5 are located. Accordingly, it possible to increase the number of qubit devices capacitively coupled to the qubit device 20-1.

FIG. 6 is a diagram (part 1) illustrating a manufacturing process of the qubit substrate according to a first embodiment. In this specification, a cross sectional view is taken along a line a-b in FIG. 2. In FIG. 6 (a), a TiN film 401 and a TiN film 402, which are conductive films, are formed on both surfaces of a Si substrate 301. For example, a Si substrate having a diameter of 3 inches and a thickness of 300 µm is used as the Si substrate 301. The material used for the conductive film may be any superconducting material, and may be Al or the like, in addition to TiN, and a thickness of the conductive film is 80 nm to 120 nm, for example. As a method of depositing the TiN film 401 and the TiN film 402, methods such as sputtering, plasma Chemical Vapor Deposition (CVD), ion plating, or the like can be used.

In FIG. 6 (b), a resist pattern having a predetermined pattern is provided on the TiN film 401, and the TiN film 401 is etched using the resist pattern as a mask, thereby obtaining a TiN pattern having a predetermined pattern of the resonators 21, bump pads 41, or the like. Thereafter, the resist pattern on the TiN pattern is removed by ashing.

When performing the process of providing the resist pattern on the TiN film 401 and the process of etching the TiN film 401 as described above, the Si substrate 301 is placed on a stage of a coater or an etcher, and in this case, the TiN film 402 formed on the rear surface of the Si substrate 301 may become damaged. In order to avoid the damage, it is preferable to form a protective film covering the TiN film 402 in advance. For example, a film obtained by curing a resist can be used for the protective film. The protective film is removed using a stripping solution after the processing with respect to the TiN film 401 ends.

Next, the processing of the TiN film 402 will be described. In the processing of the TiN film 402, a protective film is formed so as to cover the TiN pattern having the predetermined pattern of the resonators 21, the bump pads 41, or the like in order to protect the TiN pattern, and a TiN pattern 43 having a predetermined pattern is formed in a region where a control probe pad, which will be described later, is to be formed in the TiN film 402.

FIG. 7 is a diagram (part 2) illustrating a manufacturing process of the qubit substrate according to the first embodiment. A resistor pattern is provided at a predetermined position on the Si substrate 301 formed with the TiN pattern. Next, after a Al film is deposited on the entire surface, the resist pattern is removed by a lift-off to form a predetermined qubit device 20. The qubit device 20 is composed of a capacitor and a Josephson device. The method of forming the Josephson device will be described later in detail.

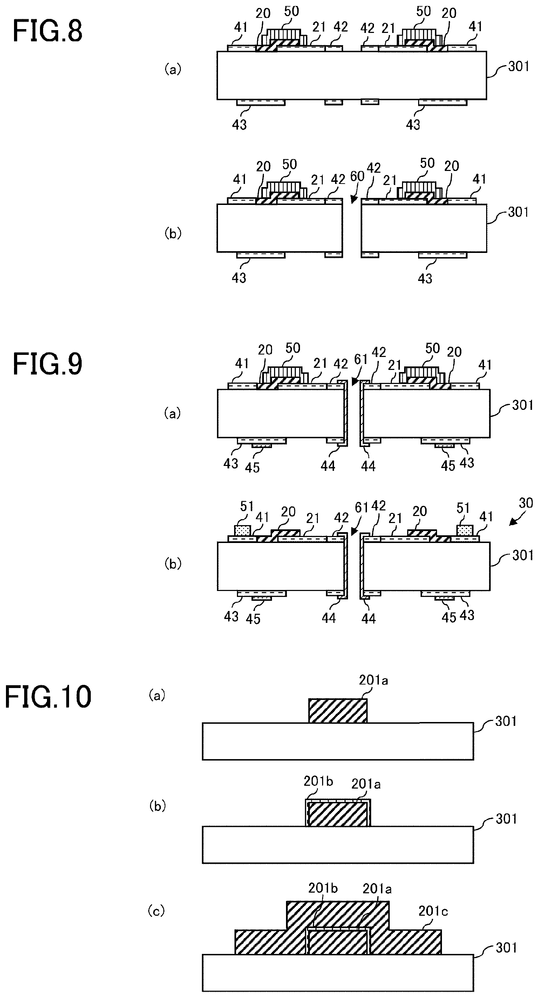

FIG. 8 is a diagram (part 3) illustrating a manufacturing process of the qubit substrate according to the first embodiment. In FIG. 8 (a), a protective film, such as a SiO₂ film 50 or the like, covering at least a portion of the qubit device 20, is formed on the qubit device 20 formed in FIG. 7 in order to prevent damage from occurring during a subsequent manufacturing process. A material used for the protective film may be an insulating material other than SiO₂, such as Si₃N₄ or the like, for example.

In FIG. 8 (b), resist patterns are provided on both surfaces of the Si substrate 301, and the Si substrate 301 is etched from both surfaces thereof by Reactive Ion Etching (RIE) using the resist patterns as masks, thereby providing a through hole 60 at a predetermined position. The through hole 60 is formed between the plurality of qubit devices 20 in FIG. 8 (b). The through hole 60 may be formed by forming the resist pattern and performing the etching with respect to one surface of the Si substrate 301.

FIG. 9 is a diagram (part 4) illustrating a manufacturing process of the qubit substrate according to the first embodiment. In FIG. 9 (a), a Al film 44 is formed inside the through hole 60 formed in FIG. 8 (b), thereby forming a conductive via 61 penetrating the Si substrate 301. In the present embodiment, Al is used as a conductive material constituting the conductive via 61, but a superconducting material, such as TiN or the like, may be used as the conductive material.

Particularly, a resist is formed in regions excluding the through hole 60 and its periphery on both surfaces of the Si substrate 301. Next, a Al film is deposited on the entire surface including an inner wall of the through hole 60 by vapor deposition. Thereafter, the Al film on the resist is removed by lift-off, thereby forming the conductive via 61 including the through hole 60 and the Al film 44. The conductive via 61 that is formed is connected to an interconnect 42 and functions as the readout port 22. A control pad 45, which is a control probe pad, may be formed simultaneously in the process of forming the Al film 44.

In FIG. 9 (b), bumps 51 are formed on the bump pads 41 of the qubit substrate by lift-off. The material used for the bumps 51 is preferably a superconducting material, and is In, for example. Finally, the SiO₂ film 50 is removed by using a stripping solution. The stripping solution is a hydrofluoric acid, for example, and may be caused to act on the SiO₂ film 50 in a liquid state or a vapor state.

FIG. 10 is a diagram illustrating a manufacturing process of the Josephson device according to the first embodiment. A method of forming the Josephson device included in the qubit illustrated in FIG. 7 will be described. In FIG. 10 (a), a first electrode 201a is formed on the Si substrate 301 using a predetermined resist pattern. In the present embodiment, the first electrode 201a is formed of Al, for example, but is not limited to Al as long as a superconducting material is used therefor.

In FIG. 10 (b), a surfaces of the first electrode 201a is oxidized to form an insulating film 201b. In the present embodiment, aluminum oxide is used to form the insulating film 201b.

In FIG. 10 (c), a second electrode 201c is formed so as to cover the insulating film 201b. The second electrode 201c is formed of the same superconducting material as the first electrode 201a.

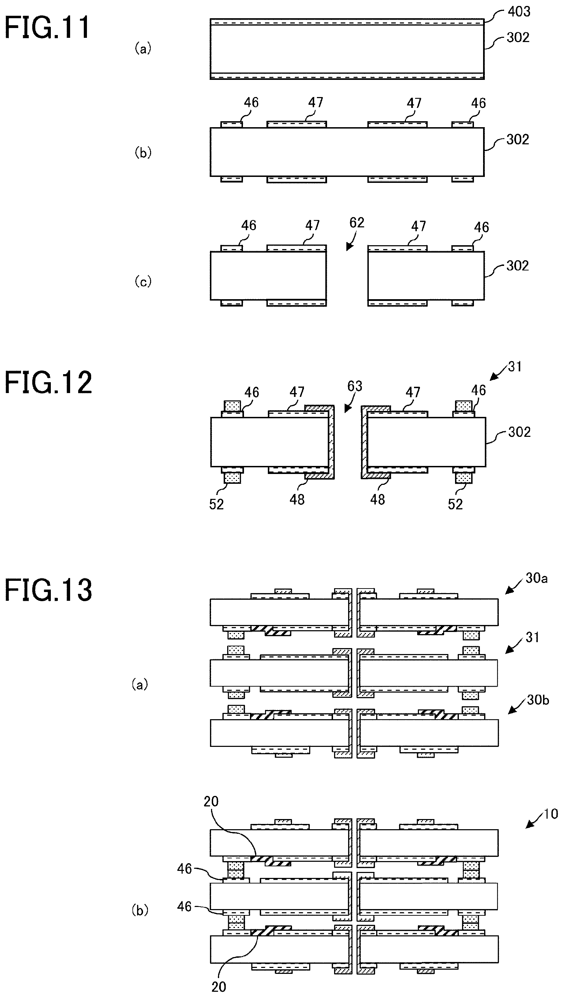

FIG. 11 is a diagram (part 1) illustrating a manufacturing process of a coupling capacitor substrate according to the first embodiment. In FIG. 11 (a), a TiN film 403, which is a conductive film, is formed on both surfaces of the Si substrate 302, similar to FIG. 6 (a). In the present embodiment, the coupling capacitor substrate has the same configuration on upper and lower surfaces thereof.

In FIG. 11 (b), a resist pattern having a predetermined pattern is provided on the TiN film 403, and the TiN film 403 is etched using the resist pattern as a mask, thereby forming a TiN pattern having a predetermined pattern of coupling capacitor electrodes 46, ground electrodes 47, or the like on both surfaces of the Si substrate 302. The two coupling capacitor electrodes 46 provided on both surfaces of the Si substrate 302 are formed at positions opposing each other via the Si substrate 302.

In FIG. 11 (c), the Si substrate 302 is etched to form a through hole 62.

FIG. 12 is a diagram (part 2) illustrating a manufacturing process of the coupling capacitor substrate according to the first embodiment. A conductive via 63 penetrating the Si substrate 302 is formed by forming a Al film 48 inside the through hole 62 formed in FIG. 11 (c), and bumps 52 are formed in predetermined regions on the coupling capacitor electrodes 46 by lift-off. The material used for the conductive via 63 may be other than Al, such as TiN. An example of the material used for the bump 52 is In. The conductive via 63 is formed to maintain both the ground electrodes 47 at the same potential, by connecting the ground electrodes 47 formed on both surfaces of the Si substrate 302. Although not illustrated in FIG. 12, the ground potential applied to the ground port 26 illustrated in FIG. 4 is applied to the ground electrodes 47 via the Si substrate 302.

FIG. 13 is a cross sectional view illustrating the quantum device according to the first embodiment. In FIG. 13 (a), two qubit substrates 30a and 30b are prepared by using the processes of FIG. 6 (a) through FIG. 9 (b), and the two qubit substrates 30a and 30b are bonded to each other via the coupling capacitor substrate 31 formed in FIG. 12, thereby forming the quantum device 10.

As illustrated in FIG. 13 (b), the two qubit substrates 30a and 30b are arranged so that the qubit devices 20 formed thereon oppose one another.

Accordingly, in the first embodiment, the plurality of qubit devices 20 formed on the same qubit substrate 30a or 30b are capacitively coupled via the capacitors 23, and further, the qubit devices 20 formed on the qubit substrate 30a and the qubit devices 20 formed on the qubit substrate 30b are capacitively coupled via the capacitors formed by the coupling capacitor electrodes 46.

The following describes a method of controlling the quantum device, functions of a coupling capacitor substrate, and advantageous features or effects obtainable in the present embodiment.

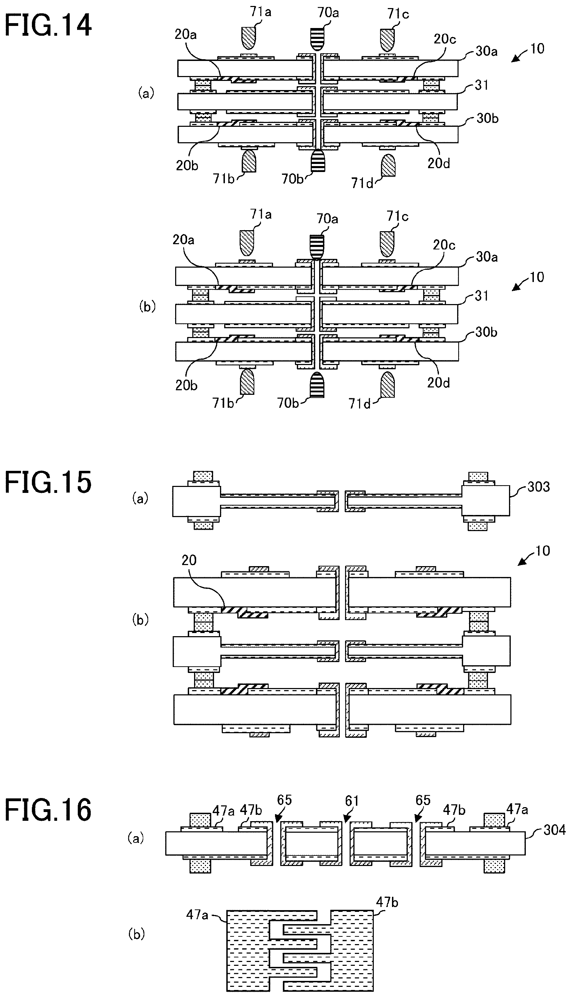

FIG. 14 is a diagram for explaining a method of controlling the quantum device according to the first embodiment. As illustrated in FIG. 1, the quantum device 10 is disposed within the refrigerator 13, the qubit device 20 is controlled by the control signal supplied from the outside of the refrigerator 13, and a readout signal according to the state of the qubit device 20 is read out. In FIG. 14, a terminal for applying the control signal to the qubit device 20 is a control probe 71, and a readout terminal for reading out the readout signal is a readout probe 70.

FIG. 14 (a) illustrates a state where the control signal is input with respect to the qubit device 20b using the control probe 71b. The control signal is a signal having a frequency component that is the same as an intrinsic frequency of the qubit device 20b, and the state of the qubit device 20b can be read out using this control signal. In this case, the state of the qubit device 20b can be read out by contacting a readout probe 70b to the readout port 22 formed on the same qubit substrate 30b as the qubit device 20b.

FIG. 14 (b) illustrates a state where a control probe 71b is used to input the control signal with respect to the qubit device 20a. In this case, the control signal is a signal having a frequency component that is the same as an intrinsic frequency of the qubit device 20a, and this control signal acts on the qubit device 20a via the coupling capacitance formed on the coupling capacitor substrate 31, thereby enabling the state of the qubit device 20a to be read via a readout probe 70a.

### <Second Embodiment>

In a second embodiment, a structure for reducing a stray capacitance component which causes crosstalk is disclosed. FIG. 15 is a cross sectional view of the quantum device according to a second embodiment. In FIG. 15, the same reference numerals are assigned to the same constituent elements as those disclosed in the first embodiment, and a description thereof will be omitted as appropriate. As illustrated in FIG. 15, at least a region of the Si substrate 303 of the coupling capacitor substrate opposing the qubit device 20 is made thin. Thus, a distance between the Si substrate 303 of the coupling capacitor substrate and the qubit device 20 is increased, and the stray capacitance component between the coupling capacitor substrate 31 and the qubit device 20 can be reduced.

### <Third Embodiment>

FIG. 16 is a diagram illustrating the structure of the coupling capacitor substrate according to a third embodiment. In the third embodiment, a coupling capacitor for capacitively coupling a plurality of qubits has a structure different from that of the first embodiment. The same constituent elements as those disclosed in the first and second embodiments are designated by the same reference numerals, and a description thereof will be omitted as appropriate.

In FIG. 16 (a), a coupling capacitor using a capacitor electrode 47a and a capacitor electrode 47b is formed on a first surface of the Si substrate 304, using TiN or the like, for example. In the plan view, the coupling capacitor has a shape illustrated in FIG. 16 (b), for example, and has a structure in which a capacitor is formed in an in-plane direction of the first surface. A planar layout of the TiN pattern can be appropriately adjusted to obtain a desired capacitance value. For example, a comb-shaped planar layout illustrated in FIG. 16 (b) may be used.

One electrode of the capacitive coupling formed on the first surface needs to be connected to the TiN pattern on a second surface. For this reason, in the present embodiment, a conductive via 65 penetrating the Si substrate 304 is formed. In FIG. 16 (a), the conductive via 65 penetrating the Si substrate 304 and electrically connecting one of the electrodes of the coupling capacitor formed on the first surface and the TiN pattern formed on the second surface to each other is formed in correspondence with each coupling capacitor. The conductive via 65 may be formed simultaneously in the process of forming the conductive via 61 disclosed in the first embodiment.

In the third embodiment, in order to adjust the capacitance value of the coupling capacitance to a set value, a distance between the electrodes and an opposing area between the electrodes are set to arbitrary values when designing the capacitor electrode 47a and the capacitor electrode 47b.

### DESCRIPTION OF REFERENCE NUMERALS

1: quantum computer
10: quantum device
11: signal generator
12: signal demodulator
13: refrigerator
20: qubit device
21: resonator
22: readout port
23, 202: capacitor
24: inter-qubit interconnect
25: control port
26: ground port
30: qubit substrate
31: coupling capacitor substrate
41: bump pad
42: interconnect
43: TiN pattern
44, 48: Al film
45: control pad
46: coupling capacitor electrode
47: ground electrode
51, 52: bump
201: Josephson device

## Claims

1. A device **characterized in that** there are provided:
a first qubit substrate;
a second qubit substrate;
a coupling capacitor substrate;
a first bump; and
a second bump,
wherein
the first qubit substrate includes a first qubit,
the second qubit substrate includes a second qubit,
the coupling capacitor substrate includes a first capacitor electrode, and a second capacitor electrode capacitively coupled to the first capacitor electrode,
the first qubit substrate and the coupling capacitor substrate are connected via the first bump so that the first qubit opposes the coupling capacitor substrate,
the second qubit substrate and the coupling capacitor substrate are connected via the second bump so that the second qubit opposes the coupling capacitor substrate, and
the first qubit and the first bump are electrically connected, the second qubit and the second bump are electrically connected, the first capacitor electrode and the first bump are electrically connected, and the second capacitor electrode and the second bump are electrically connected.

2. The device as claimed in claim 1, **characterized in that**:
the first qubit is formed on a first surface of the first qubit substrate,
the first qubit substrate further includes a first readout port and a first control port formed on a second surface of the first qubit substrate,
the second qubit is formed on a third surface of the second qubit substrate, and
the second qubit substrate further includes a second readout port and a second control port formed on a fourth surface of the second qubit substrate.

3. The device as claimed in claim 1 or 2, **characterized in that**:
the coupling capacitor substrate includes a fifth surface and a sixth surface,
the first capacitor electrode is formed on the fifth surface,
the second capacitor electrode is formed on the sixth surface, and
the first capacitor electrode is capacitively coupled to the second capacitor electrode.

4. The device as claimed in claim 1 or 2, **characterized in that**:
the coupling capacitor substrate includes a fifth surface and a sixth surface,
the first capacitor electrode and the second capacitor electrode are formed on the fifth surface of the coupling capacitor substrate, and
the first capacitor electrode is capacitively coupled to the second capacitor electrode.

5. The device as claimed in claim 4, **characterized in that**:
the first capacitor electrode and the second capacitor electrode are comb-shaped, respectively.

6. The device as claimed in claim 1 or 2, **characterized in that**:
the coupling capacitor substrate includes a Si substrate, and
a thickness of the Si substrate in a region opposing the first qubit or the second qubit is smaller than a thickness in a region where the first bump and the second bump are formed.

7. A manufacturing method for a device, **characterized in that** there are provided the steps of:
connecting a first qubit substrate having a first qubit and a coupling capacitor substrate having a first capacitor electrode and a second capacitor electrode capacitively coupled to the first capacitor electrode, by a first bump so that the first qubit opposes the coupling capacitor substrate; and
connecting a second qubit substrate having a second qubit and the coupling capacitor substrate, by a second bump so that the second qubit opposes the coupling capacitor substrate,
wherein the first qubit and the first bump are electrically connected, the second qubit and the second bump are electrically connected, the first capacitor electrode and the first bump are electrically connected, and the second capacitor electrode and the second bump are electrically connected.

8. The manufacturing method for the device as claimed in claim 7, **characterized in that**:
the first qubit is formed on a first surface of the first qubit substrate,
the first qubit substrate further includes a first readout port and a first control port formed on a second surface of the first qubit substrate,
the second qubit is formed on a third surface of the second qubit substrate, and
the second qubit substrate further includes a second readout port and a second control port formed on a fourth surface of the second qubit substrate.

9. The manufacturing method for the device as claimed in claim 7 or 8, **characterized in that**:
the coupling capacitor substrate has a fifth surface and a sixth surface,
the first capacitor electrode is formed on the fifth surface,
the second capacitor electrode is formed on the sixth surface, and
the first capacitor electrode is capacitively coupled to the second capacitor electrode.

10. The manufacturing method for the device as claimed in claim 7 or 8, **characterized in that**:
the coupling capacitor substrate has a fifth surface and a sixth surface,
the first capacitor electrode and the second capacitor electrode are formed on the fifth surface of the coupling capacitor substrate, and
the first capacitor electrode is capacitively coupled to the second capacitor electrode.

11. The manufacturing method for the device as claimed in claim 10, **characterized in that**:
the first capacitor electrode and the second capacitor electrode are comb-shaped, respectively.

12. The manufacturing method for the device as claimed in claim 7 or 8, **characterized in that**:
the coupling capacitor substrate includes a Si substrate, and
a thickness of the Si substrate in a region opposing the first qubit or the second qubit is smaller than a thickness in a region where the first bump and the second bump are formed.
